# EUROPEAN PATENT SPECIFICATION

(11) **EP 4 474 837 B1**
(45) Date of publication and mention of the grant of the patent: **24.06.2026**
(21) Application number: 23775355.3
(22) Date of filing: 24.03.2023
(51) Int. Cl.: G06N 5/01, G06N 20/20, G01R 31/36, G05B 23/02, H01M 10/04, H01M 10/42, H01M 10/48

(54) **BATTERY CELL PROCESS DATA ANALYSIS SYSTEM AND METHOD**
SYSTEM UND VERFAHREN ZUR ANALYSE VON BATTERIEZELLENPROZESSDATEN
SYSTÈME ET PROCÉDÉ D'ANALYSE DE DONNÉES DE PROCESSUS DE CELLULE DE BATTERIE

(30) Priority: 25.03.2022 KR 20220037600
(43) Date of publication of application: 11.12.2024
(73) Proprietor: LG Energy Solution, Ltd., Seoul 07335 (KR)
(72) Inventor: NAM, Kwan Woo, Daejeon 34122 (KR)
(74) Representative: Plasseraud IP
(86) International application number: PCT/KR2023/003955
(87) International publication number: WO 2023/182860

(56) References cited:
- JP-A- 2019 102 186
- KR-A- 20090 020 362
- KR-A- 20130 113 296
- KR-A- 20190 100 500
- KR-A- 20200 119 383
- KR-A- 20200 119 383
- US-A1- 2013 268 466

## Description

### [TECHNICAL FIELD]

### CROSS-REFERENCE TO RELATED APPLICATION

This application claims priority to and the benefit of Korean Patent Application No. 10-2022-0037600 filed in the Korean Intellectual Property Office on March 25, 2022.

### TECHNICAL FIELD

Embodiments disclosed herein relate to a battery cell process data analysis system and a battery cell process data analysis method using the same.

### [BACKGROUND ART]

A lithium polymer battery, a type of secondary batteries, is a battery capable of repeating charge and discharge through reversible mutual conversion between chemical energy and electrical energy, and has been used variously for portable electronic devices, electric vehicle batteries, etc., due to the advantage of long life and large capacity. A battery capacity, which is one of most important performance indices of a battery cell, may be affected by numerous process factors involving a manufacturing process. Conventionally, a process has been managed through simple correlation analysis with a capacity centering on a design factor of the battery cell (i.e., a variable controllable in a battery design process), but the actual battery cell manufacturing process includes multiple discontinuous processes with different characteristics, such as an electrode process, an assembly process, an activation process, etc., and various process factors other than the design factor may affect the capacity of the battery cell. The effect of these process factors on the capacity of the battery cell is generally irregular, and several processes rather than a single process simultaneously affect the capacity of the battery cell, making it difficult to clearly find out a correlation therebetween.

Document US 2013/268466 discloses a system for predicting lifetime of a battery of the related art.

### [DISCLOSURE]

### [TECHNICAL PROBLEM]

Embodiments disclosed herein aim to provide a battery cell process data analysis system and method in which process factors affecting a capacity of a battery cell may be found through artificial intelligence-based data analysis.

Embodiments disclosed herein also aim to improve a capacity quality of a produced battery cell by finding a process factor that positively affects the capacity of the battery cell (e.g., that makes an actual capacity greater than a designed capacity) and a process factor that negatively affects the capacity of the battery cell (e.g., makes the actual capacity less than the designed capacity) and managing the process factors.

Technical problems of the embodiments disclosed herein are not limited to the above-described technical problems, and other unmentioned technical problems would be clearly understood by one of ordinary skill in the art from the following description.

### [TECHNICAL SOLUTION]

A battery cell process data analysis system according to an embodiment is defined in the appended claims.

A battery cell process data analysis method according to an embodiment is also provided.

### [ADVANTAGEOUS EFFECTS]

According to the battery cell process data analysis system and method of the foregoing embodiment, the process factors affecting the capacity of the battery cell may be found through artificial intelligence-based data analysis. Moreover, by connecting data of different processes by using a key index, multiple process factors affecting a battery capacity in each process operation may be integrally managed.

Furthermore, it is possible to improve a capacity quality of a produced battery cell by finding a process factor that positively affects the capacity of the battery cell (e.g., that makes an actual capacity greater than a predicted capacity) and a process factor that negatively affects the capacity of the battery cell (e.g., makes the actual capacity less than the predicted capacity) and managing the process factors.

Moreover, various effects recognized directly or indirectly from the disclosure may be provided.

### [DESCRIPTION OF DRAWINGS]

In order to more clearly describe technical solutions of embodiments disclosed herein or the prior art, the drawings required in the description of the embodiments are briefly introduced below. It should be understood that the following drawings are for the purpose of explaining the embodiments of the present specification and not for limiting purposes. In addition, representations of some components in the drawings may be exaggerated or omitted for clarity of explanation.
FIG. 1 is a graph showing an expected distribution and an actual distribution of a measured actual capacity with respect to a predicted capacity calculated for a plurality of battery cells.
FIG. 2 is a block diagram showing a configuration of a battery cell process data analysis system according to an embodiment.
FIG. 3 is a schematic diagram showing that process factors of various process operations included in a battery cell manufacturing process affect the capacity of a completed battery cell.
FIG. 4 is a schematic diagram showing that process data of several processes included in a battery cell manufacturing process is connected using a key index.
FIG. 5 shows how to measure an electrode size to calculate a predicted capacity of a battery mono cell.
FIG. 6 is a graph showing distribution data of a measured actual capacity with respect to a predicted capacity for multiple battery cells.
FIG. 7 shows that capacity distribution data of a battery cell is classified into two groups by using an artificial intelligence model according to an embodiment.
FIG. 8 shows that capacity distribution data of a battery cell is classified into three groups by using an artificial intelligence model according to an embodiment.
FIG. 9 is a flowchart of a battery cell process data analysis method according to an embodiment.
FIG. 10 is a flowchart showing in more detail an operation of determining a process factor of FIG. 9.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

Although terms used herein are selected with general terms popularly used at present under the consideration of functions in the disclosure, the terms may vary according to the intention of those of ordinary skill in the art, custom, or introduction of new technology. In addition, in a specific case, the applicant voluntarily may select terms, and in this case, the meaning of the terms may be disclosed in a corresponding description part of the present specification. Therefore, the terms used herein should be defined not by the simple names of the terms but by the substantial meaning of the terms and the contents throughout the disclosure. Moreover, terms defined in the present disclosure are used for only describing a specific exemplary embodiment and may not have an intention to limit the scope of other exemplary embodiments.

Herein, it is to be understood that the singular forms include plural references unless the context clearly dictates otherwise. Herein, expressions such as "first" and "second" are used to distinguish components from each other, and do not mean a rank or order among components.

Hereinbelow, preferred embodiments of a battery cell process data analysis system and a battery cell process data analysis method using the same will be described with reference to the drawings.

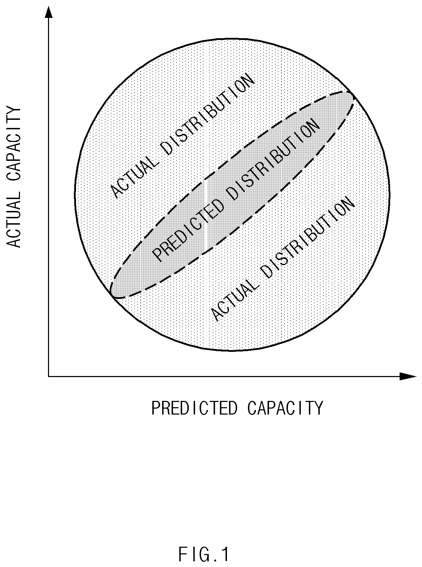

FIG. 1 is a graph showing a distribution of a predicted capacity and a measured actual capacity for multiple battery cells, and as shown, the predicted capacity and the actual capacity have a linear relationship according to a predicted distribution, but in practice, tend to be more widely distributed due to an influence of various process factors. That is, in an actual distribution, due to an influence of unexpected process factors, the measured actual capacity may be less (a lower side of an expected distribution range) or greater (an upper side of the expected distribution range) than the calculated predicted capacity. The effect of these process factors on the capacity of the battery cell is generally irregular, and several processes rather than a single process simultaneously affect the capacity of the battery cell, making it difficult to clearly find out a correlation therebetween.

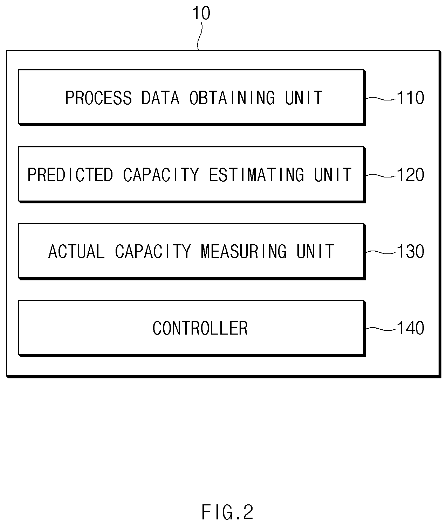

FIG. 2 is a block diagram showing a configuration of a battery cell process data analysis system according to an embodiment, to solve the foregoing problem.

Referring to FIG. 2, a battery cell process data analysis system 10 according to an embodiment may include a process data obtaining unit 110, a predicted capacity estimating unit 120, an actual capacity measuring unit 130, and a controller 140. Components shown in the block diagram are classified depending on their functions and roles, and each block does not necessarily have to be implemented as independent hardware or software. For example, separated components may be actually implemented as one device or program, or one component may be implemented as a combination of several devices and programs.

The process data obtaining unit 110 may obtain process data of a battery cell. Herein, the process data of the battery cell may relate to several processes included in a battery manufacturing process, such as an electrode process, an assembly process, an activation process, etc., and include multiple process factors (i.e., process variables) affecting a capacity of a produced battery cell. For example, a loading amount of an electrode material per unit area, a size and a thickness of an electrode, etc., may correspond to process factors in the electrode process, a method for loading an anode, a separator, and a cathode, the amount of an electrolyte, etc., may correspond to the process factors in the assembly process, and the number of times of charging and discharging a cell, a temperature and a pressure during charge and discharge, etc., may correspond to the process factors in the activation process. The listed data types are only examples, and various process data related to process operations that may affect the capacity of a battery cell may be used.

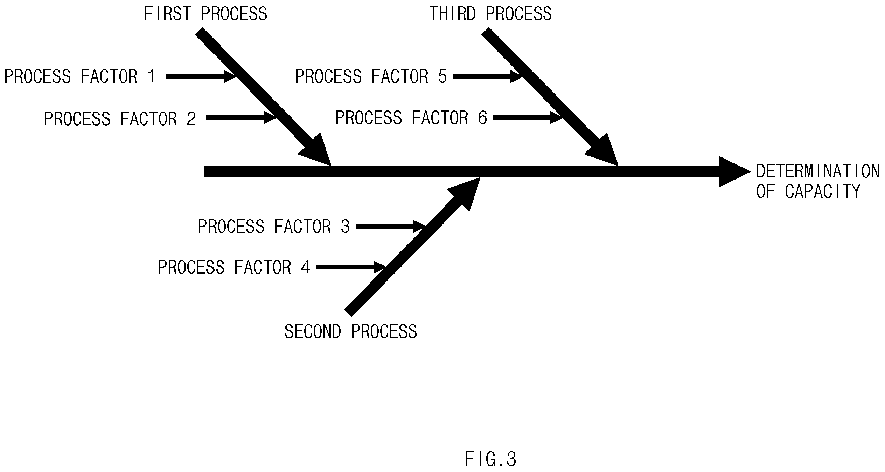

FIG. 3 is a schematic diagram showing that process factors of various process operations included in a battery cell manufacturing process affect the capacity of a completed battery cell.

Referring to FIG. 3, various processes (first to third processes) and process factors (process factors 1 to 6) involving these processes may have an influence upon determining a capacity of a battery cell. To find a process factor having a great influence (or a process factor having a positive/negative influence) upon a difference between a theoretically calculated predicted capacity and a measured actual capacity among such process factors, the process data obtaining unit 110 may collect process data in each process.

According to an embodiment, the process data obtaining unit 110 may connect process data related to different processes by using a key index, thereby generating integrated process data. Conventionally, experienced engineers directly find and manage design factors or process factors that affect a battery cell capacity based on personal experiences. Although this method is effective for managing an individual process (e.g., one of the electrode process, the assembly process, and the activation process), it is difficult to determine correlation between process factors in several process operations, such that the method is not effective as the process steps become complicated. That is, some process factors may affect each other as dependent variables rather than independent variables for the battery capacity, it is advantageous to integrate and manage process data of several process operations. To this end, it is necessary to connect these data by considering the correlation between the process data of each process.

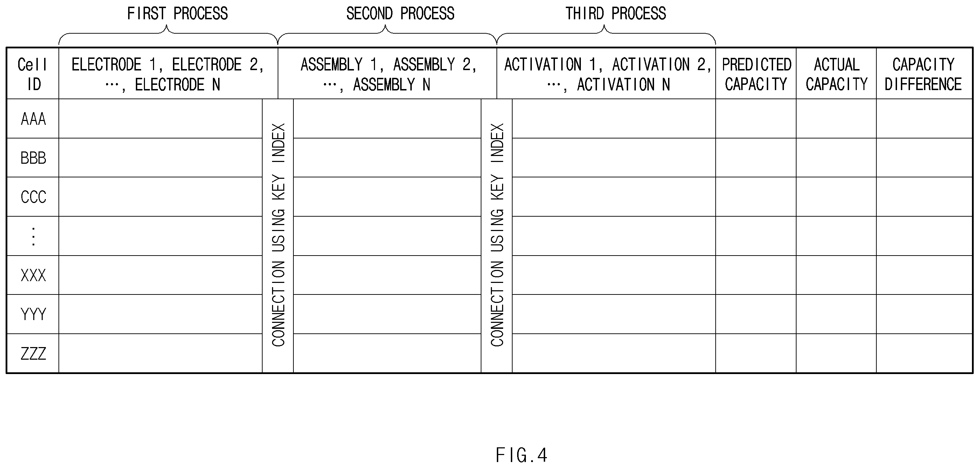

FIG. 4 is a schematic diagram showing that process data of several processes included in a battery cell manufacturing process is connected using a key index.

Referring to FIG. 4, for a plurality of battery cells AAA to ZZZ, process data (Electrode 1, Electrode 2, ..., Electrode n) of a first process (e.g., the electrode process), process data (Assembly 1, Assembly 2, ..., Assembly n) of a second process (e.g., the assembly process), and process data (Activation 1, Activation 2, ..., Activation n) of a third process (e.g., the activation process) may be connected using a key index to generate integrated process data. In this case, the key index may be set considering correlation between processes.

The key index may differ with a type of data generated in a process. For example, for a mono cell assembly process, an ID is given to each mono cell, such that a key index for connecting IDs of a plurality of mono cells to an ID of one completed cell may be set. In this way, for the assembly process, individual data exists discontinuously, enabling connection between processes through ID tracking.

For the electrode process, there is continuous time-series data under one electrode ID by a roll-to-roll process. Thus, when the electrode process and the assembly process are connected, process data may be interconnected by tracking an ID of an electrode put into the assembly process and data in chronological order or reverse chronological order within one electrode ID.

The integrated process data may be input to an artificial intelligence model described below, and the artificial intelligence model may determine process factors having a significant influence upon a capacity of a battery cell based on the integrated process data. As such, by integrally managing process data of several process operations, an influence of each process factor upon a battery capacity may be easily and accurately recognized.

The predicted capacity estimating unit 120 may estimate the predicted capacity of the battery cell based on the process data. Herein, the predicted capacity may mean a theoretical maximum capacity calculated based on a design variable of the battery cell. According to an embodiment, a size of an electrode (e.g., a size of a positive electrode or a negative electrode) may be calculated from vision data obtained by photographing upper and lower surfaces of a mono cell (a unit cell including a positive electrode, a negative electrode, and a separator), and a theoretical capacity the battery cell may electrically have may be estimated based on the size of the electrode and the amount of an electrode active material loaded on the electrode.

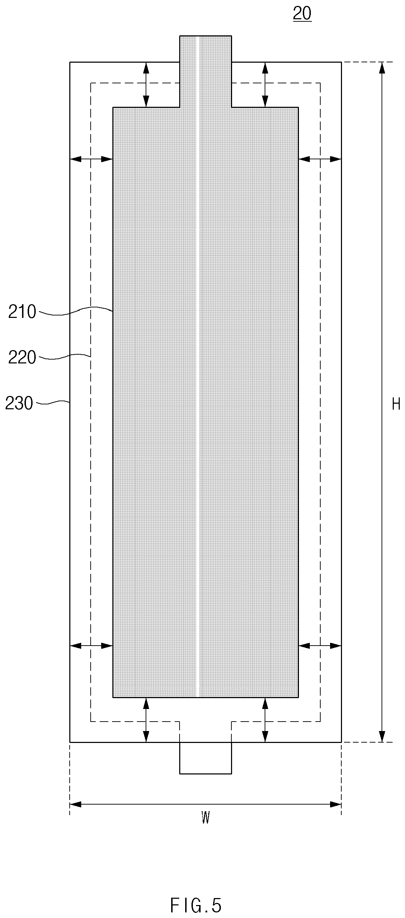

FIG. 5 shows how to measure an electrode size to calculate a predicted capacity of a battery mono cell.

Referring to FIG. 5, a mono cell 20 may include a positive electrode 210, a negative electrode 220, and a separator 230 sandwiched therebetween to separate the positive electrode and the negative electrode from each other. By using the vision data obtained by photographing the upper and lower surfaces of the monocell, a distance from each part of the positive electrode 210 to an end of the separator 230 (see an arrow of FIG. 5) may be recognized. A horizontal length W of the separator 230 is already known as a design variable, such that a horizontal length of the positive electrode 210 may be calculated by subtracting a horizontal distance (see an arrow) between the positive electrode 210 and the separator 230 from the horizontal length W of the separator 230. Likewise, a vertical length H of the separator 230 is already known as a design variable, such that a vertical length of the positive electrode 210 may be calculated by subtracting a vertical distance (see an arrow) between the positive electrode 210 and the separator 230 from the vertical length H of the separator 230.

The size of the positive electrode may be calculated from the horizontal length and the vertical length of the positive electrode, and a theoretical predicted capacity of the individual mono cell 20 may be calculated by substituting the amount of an active material per unit area. In addition, one battery cell has a stacked structure of several mono cells, such that by summing a predicted capacity of each mono cell, the theoretical predicted capacity of the battery cell may be estimated. The above-described method of calculating the size of the electrode is assumed to consider a designated design variable, but this is merely an example. According to an embodiment, a method may be considered which identifies designated entities (e.g., a positive electrode, a negative electrode, and a separator) using an image processing algorithm in the vision data obtained by photographing the upper and lower surfaces of the mono cell, and calculates the sizes of the identified entities to calculate the size of an electrode.

The size of the positive electrode is used because the capacity of the battery cell is determined by the size of the positive electrode and the amount of the loaded electrode active material, generally in a lithium-ion battery, but the present disclosure is not limited thereto. For example, according to a design, when the capacity of the battery cell is determined by the size of the negative electrode and the amount of the loaded electrode active material, the predicted capacity estimating unit 120 may estimate a theoretical capacity of the battery cell based on the size of the negative electrode 220 and the amount of an electrode active material corresponding thereto.

The actual capacity measuring unit 130 may measure the actual capacity of the completed battery cell. Measurement of the capacity of the battery cell may be generally performed through cell current measurement after charge and discharge processes, but measurement timing and method are not separately limited.

The controller 140 may calculate a difference between the predicted capacity of the battery cell estimated by the predicted capacity estimating unit 120 and the actual capacity of the battery cell measured by the actual capacity measuring unit 130, and determine a process factor affecting the difference in capacity by using a trained artificial intelligence model.

To this end, the controller 140 may obtain distribution data of an actual capacity with respect to a predicted capacity for multiple battery cells manufactured through a process.

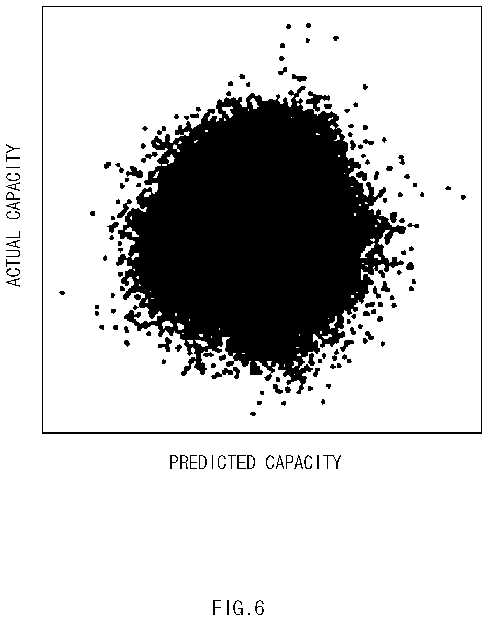

FIG. 6 is a graph showing distribution data of a measured actual capacity with respect to a predicted capacity for multiple battery cells.

Referring to FIG. 6, in the graph, a horizontal axis indicates a predicted capacity estimated based on a mono cell vision data and a vertical axis indicates an actual capacity measured through inspection of a completed batter cell, in which respective dots may indicate a predicted capacity and an actual capacity of battery cells. As is shown , even battery cells passing through the same manufacturing process may have different predicted capacities according to an electrode size of a mono cell, and their actual capacities may also have large and small errors due to process factors affecting various influences through various processes. In particular, when an actual capacity is much smaller than a predicted capacity (i.e., points in a relatively low side of the graph), quality degradation of a product may occur and thus it is necessary to find and manage a process factor that affects such a result.

To determine a process factor that affects a difference between the actual capacity and the predicted capacity, the controller 140 may classify points into two or more groups according to a set classification criterion (e.g., according to a size of the actual capacity with respect to a predicted capacity of the battery cell on distribution data) by using a clustering algorithm and/or a first artificial intelligence model.

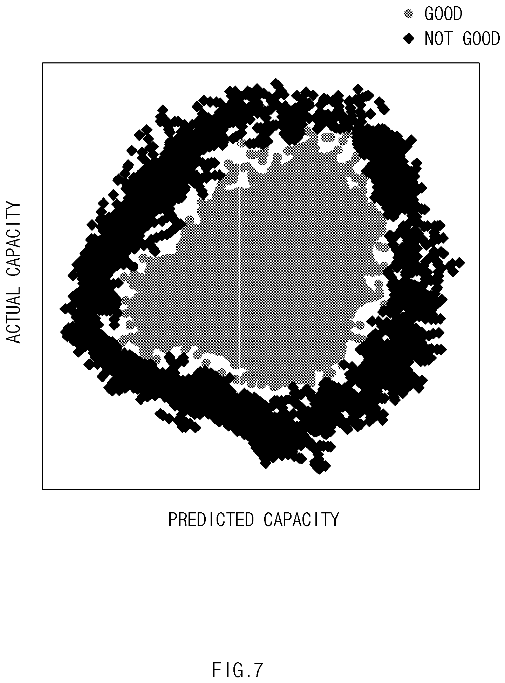

According to an embodiment, the clustering algorithm may be a density-based spatial clustering of applications with noise (DBSCAN) algorithm. Herein, the DBSCAN algorithm is an algorithm for classifying each point as a core point, a border point, or a noise point based on whether a designated number of points fall within a designated radius from each of points indicating predicted capacities and actual capacities of battery cells. The core point may be a point including a designated number of points or more within the range. The border point may be a point including points less than the designated number of points within the range, and the included points may include the core point. The noise point may be a point including points less than the designated number of points within the range, and the included points may not include the core point. Herein, the size and number of radius may be predefined by a user. According to an embodiment, two or more groups classified according to the size of the actual capacity with respect to the predicted capacity of the battery cell on the distribution data may be clusters including different core points and border points. The noise points may not be included in the two or more groups. Referring to FIG. 7, points classified as 'GOOD' may belong to a first cluster including core points and border points, and points classified as 'NOT GOOD' may belong to a second cluster including other core points and other border points. Herein, the first cluster and the second cluster may be referred to as two or more groups.

According to an embodiment, the first artificial intelligence model, which is a machine learning-based classification model, discretize and/or classify adjacent data to improve classification performance. For example, the first artificial intelligence model may use a DB SCAN-based model, without being limited thereto. For example, when the first artificial intelligence model is based on DBSCAN, the first artificial intelligence model be supervised and trained based on training data. For example, the first artificial intelligence model may be trained to minimize a difference between a core point, a border point, or a noise point output by the first artificial intelligence model and a core point, a border point, or a noise point labelled on learning data.

FIG. 7 shows that capacity distribution data of a battery cell is classified into two groups by using an artificial intelligence model according to an embodiment.

In FIG. 7, the points classified as 'GOOD' may indicate battery cells having a relatively small difference between a theoretically estimated predicted capacity and an actual capacity, and the points classified as 'NOT GOOD' may indicate battery cells having a relatively large difference between a predicted capacity and an actual capacity. As described above, a large difference between a predicted capacity and an actual capacity may lead to quality degradation of a product, and thus it is necessary to find and manage a process factor that affects such a result.

The controller 140 may calculate an importance indicating an influence of each process factor upon the capacity of the battery cell by analyzing distribution data belonging to each group (e.g., a group classified as 'GOOD' or a group classified as 'NOT GOOD') and process data of the battery cell corresponding thereto), by using a second artificial intelligence model.

According to an embodiment, the second artificial intelligence model may be trained to calculate an importance of each process factor based on a change of the distribution data corresponding to a change or presence/absence of the process factor, for two or more preset process factors. The second artificial intelligence model may be based on a model using, for example, an ensemble-based boosting method (e.g., a gradient boost for classification, XGBoost (e.g., XGBClassifier, LightGBMClassifier, etc.). Herein, an ensemble may be a method for generating a prediction result by combining a plurality of models (e.g., decision trees).

In an embodiment, the second artificial intelligence model may recognize importances among a plurality of process factors by combining decision trees for each of the plurality of process factors. Herein, each of the decision trees may include two leaves branched from one decision node.

In an embodiment, the second artificial intelligence model may be trained to minimize a difference between a capacity difference of battery cells classified in final leaves and a predicted value of the final leave (i.e., a pseudo-residual (or an error) value). Herein, the second artificial intelligence model may be configured with decision trees of a designated depth. The designated depth may be determined as an integer between 8 and 32.

The second artificial intelligence model may be trained using process data of the first to third processes as input data and a capacity difference as a predicted value. The second artificial intelligence model may be trained through a process of calculating a pseudo-residual of each of leaves of the current decision tree, a process of generating a child decision tree of the current decision tree, and a process of generating a predicted value of each of the leaves included in the child decision tree.

Each of the leaves may indicate a pseudo-residual (or an error) value. Herein, a pseudo-residual of each of leaves of an n^{th} decision tree may be calculated based on a difference between a capacity difference between battery cells classified in each leaf of the n^{th} decision tree and a predicted value Pₙ₋₁ determined in a previous decision tree.

Herein, a predicted value for a capacity difference between battery cells included in each leaf of the n^{th} decision tree may be calculated based on a pseudo-residual of each leaf of the n^{th} decision tree. An initial predicted value P₀ may be set as an average value of capacity differences of all battery cells. A predicted value Pₙ for each leaf of the nth decision tree may be a sum (Pₙ= Pₙ₋₁ + η * Oₙ) of the predicted value Pₙ₋₁ of the previous decision tree and a product of an output value Oₙ of the leaf of the current decision tree and a weight value η (e.g., 0.1). Herein, the output value Oₙ of the leaf of the current decision tree may be calculated based on pseudo-residuals of battery cells included in the leaf. For example, the output value Oₙ may be an average value of pseudo-residuals. That is, the output value Oₙ of each leaf of the nth decision tree may be a result (S = R/M) of dividing a sum (R = r₁ + r₂ + ... + r_{M}) of pseudo-residuals of battery cells included in each leaf of the nth decision tree by the number M of battery cells included in the leaf. For example, an output value of a first leaf of the n^{th} decision tree and an output value of a second leaf of the n^{th} decision tree may be different from each other.

A decision tree branched from the previous decision tree may be determined based on a gain value. For example, decision trees for each of two leaves included in the previous decision tree may be determined based on a gain value. That is, decision trees may be different for each of the two leaves. For example, a decision tree having the greatest gain value, among gain values of a candidate decision tree for classifying presence/absence of a process factor 2, a decision tree for classifying presence/absence of a process factor 3, ..., and a decision tree for classifying presence/absence of a process factor N, as decision tree candidates of a first leaf of the previous decision tree, may be determined as a decision tree for the first leaf of the previous decision tree. Herein, a gain value of each candidate decision tree may be calculated based on a similarity score of each candidate decision tree, and a similarity score S may be a result (S = (R^2)/M) of dividing a square (R^2) of a sum (R = r₁ + r₂ + ... + r_{M}) of pseudo-residuals of battery cells included in each leaf of each decision tree by the number M of battery cells. Herein, a similarity score of a decision tree may include a similarity score S₁ of the first leaf and a similarity score S₂ of the second leaf. A gain value may be a result of subtracting a similarity score of a parent node from a sum of the similarity score S₁ of the first leaf and the similarity score S₂ of the second leaf.

In an embodiment, a decision node may classify presence/absence of each process factor or classify each battery cell into one of two leaves through classification based on a reference value of each process factor. For example, a first decision node may query presence/absence of a process factor 1 in the first process. The first decision node may assign Cell IDs including the processor factor 1 to a first leaf of the corresponding decision node in the first process, and assign Cell IDs not including the process factor 1 to a second leaf of the first decision node. A second decision node may query presence/absence of a process factor 2 in the first process. The second decision node may assign Cell IDs including the processor factor 2 to a first leaf of the second decision node in the first process, and assign Cell IDs not including the process factor 2 to a second leaf of the second decision node. Herein, the first decision node and the second decision node may be connected to each other. For example, a determination process of the second decision node may be performed for battery cells assigned to the first leaf of the first decision node. In this case, the first decision node may be a parent node of the second decision node, or a previous node.

In an embodiment, the second artificial intelligence model may calculate an importance of each process factor through a permutation importance scheme based on process data classified into two or more groups. Herein, the importance of the process factor may be based on a gain value of a decision tree in which the process factor is used among decision trees. For example, a sum of gain values of a decision tree for querying presence/absence of the first process factor may be evaluated as an importance of the first process factor. However, a type and a utilization method of a model are merely examples and thus are not limited thereto.

For example, the second artificial intelligence model may compare a capacity difference (a difference between a predicted capacity and an actual capacity) calculated except for intervention of the process factor 1 among process data with a capacity difference calculated except for intervention of the process factor 2 to find out which one of the process factor 1 and the process factor 2 has a greater influence upon a difference between a predicted capacity and an actual capacity. According to this scheme, capacity differences (distribution data) between all process factors included in the process data according to presence/absence of intervention of a corresponding process factor may be compared, thereby calculating an importance of each process factor.

As such, the controller 140 may determine a process factor that affects a capacity of a battery cell based on an importance of each process factor calculated using an artificial intelligence model. Once the process factor is determined, the process factor may be controlled through proper feedback, thereby improving capacity quality of the battery cell.

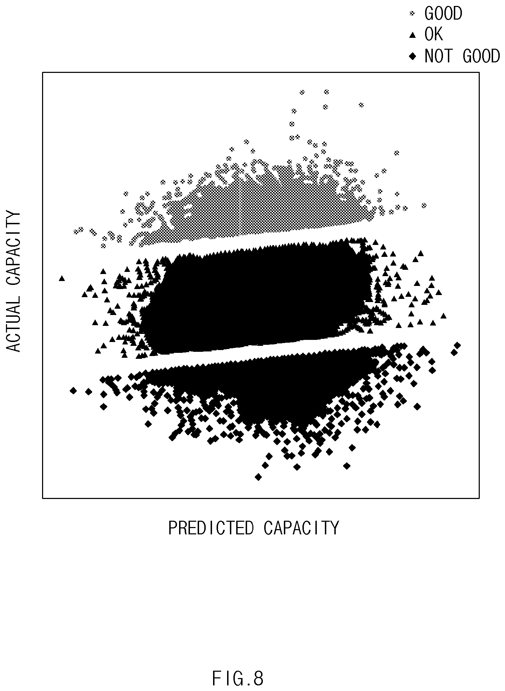

According to an additional embodiment, the controller 140 may classify distribution data of an actual capacity with respect to a predicted capacity of a battery cell into three or more groups. Unlike in FIG. 7 where distribution data is classified into two groups, FIG. 8 shows that capacity distribution data of a battery cell is classified into three groups ('GOOD', 'OK', 'NOT GOOD') by using an artificial intelligence model according to an embodiment.

More specifically, the controller 140 may classify the distribution data as a first group 'GOOD' when a size of an actual capacity with respect to an input predicted capacity of a battery cell is greater than or equal to a first threshold value, classify the distribution data as a second group 'NOT GOOD' when the size of the actual capacity with respect to the input predicted capacity of the battery cell is less than or equal to a second threshold value, and classify the distribution data as 'OK' for the other cases.

Herein, the battery cell belonging to the first group 'GOOD' may be regarded as having a relatively good quality because the actual capacity is greater than the theoretically predicted capacity. Thus, for the distribution data belonging to the first group, the controller 140 may determine a process factor having an important influence upon a capacity difference of a battery cell as a positive process factor. On the other hand, the battery cell belonging to the second group 'NOT GOOD' may be regarded as having a relatively low quality because the actual capacity is less than the theoretically predicted capacity. Thus, for the distribution data belonging to the second group, the controller 140 may determine a process factor having an important influence upon a capacity difference of a battery cell as a negative process factor. Moreover, in a subsequent battery manufacturing process, by increasing an influence of a positive process factor and decreasing an influence of a negative process factor, the quality of a battery cell capacity may be improved.

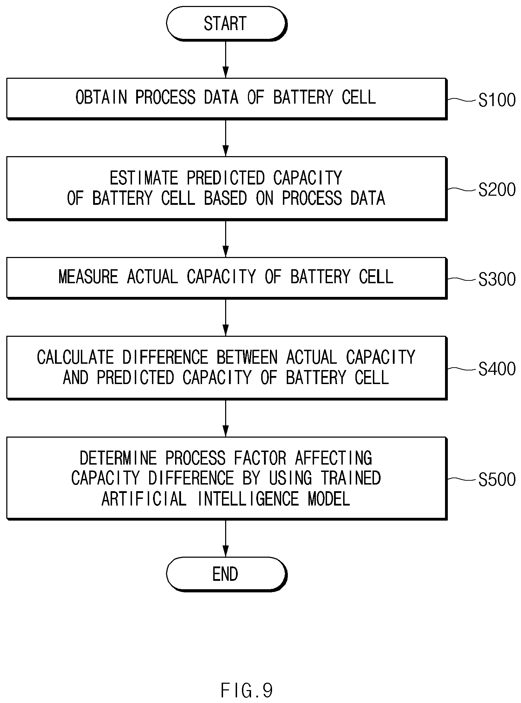

FIG. 9 is a flowchart of a battery cell process data analysis method according to an embodiment. Each operation of the method according to an embodiment may be performed by components of the battery cell process data analysis system 10 described with reference to FIG. 1, i.e., one of the process data obtaining unit 110, the predicted capacity estimating unit 120, the actual capacity measuring unit 130, and the controller 140 or a combination thereof, but the system 10 is not necessarily required to perform the current method.

Referring to FIG. 9, operation S100 of obtaining process data of a battery cell may be performed. According to an embodiment, the process data of the battery cell may include data related to several processes included in a battery manufacturing process, such as an electrode process, an assembly process, and an activation process.

Moreover, integrated process data may be generated by connecting process data related to different processes by using a key index in operation S100, and a process factor affecting a difference between a predicted capacity and an actual capacity of the battery cell may be determined among process factors related to different processes by using the integrated process data. As such, by integrally managing process data of several process operations, an influence of each process factor upon a battery capacity may be easily and accurately recognized.

Next, operation S200 of estimating the predicted capacity of the battery cell based on process data may be performed. The predicted capacity may mean a theoretical maximum capacity calculated based on a design variable of the battery cell. According to an embodiment, operation S200 may include an operation of calculating a size of an electrode of an individual mono cell based on a measured value of the mono cell and an operation of estimating a predicted capacity of a battery cell where a plurality of individual mono cells are stacked, based on the size of the electrode and the amount of an electrode active material loaded on the electrode. More specifically, an electrode size (e.g., a size of a positive electrode or a negative electrode) may be calculated from vision data obtained by photographing upper and lower surfaces of a mono cell (a unit cell including a positive electrode, a negative electrode, and a separator), and a theoretical capacity the battery cell may electrically have may be estimated based on them. A process of calculating the size of the positive electrode from the vision data of the ono cell is already described with reference to FIG. 5. Moreover, as described above, depending on a design, the theoretical capacity of the battery cell may be estimated based on the size of the negative electrode and the amount of the electrode active material corresponding thereto.

Next, operation S300 of measuring an actual capacity of a completed battery cell may be performed. As described above, measurement of the capacity of the battery cell may be generally performed through cell current measurement after charge and discharge processes, but measurement timing and method are not separately limited.

Next, operation S400 of calculating a difference between the actual capacity and the predicted capacity of the battery cell may be performed. The calculated capacity difference may be used to determine main process factors affecting the capacity difference of the battery cell in the next operation.

Next, operation S500 of determining a process factor affecting the capacity difference by using a trained artificial intelligence model may be performed. Even battery cells passing through the same manufacturing process may have different predicted capacities according to an electrode size of a mono cell or the amount of a loaded electrode active material, and their actual capacities may also have large and small errors due to process factors affecting various influences through various processes. In particular, when an actual capacity is much smaller than a predicted capacity, quality degradation of a product may occur and thus it is necessary to find and manage a process factor that affects such a result.

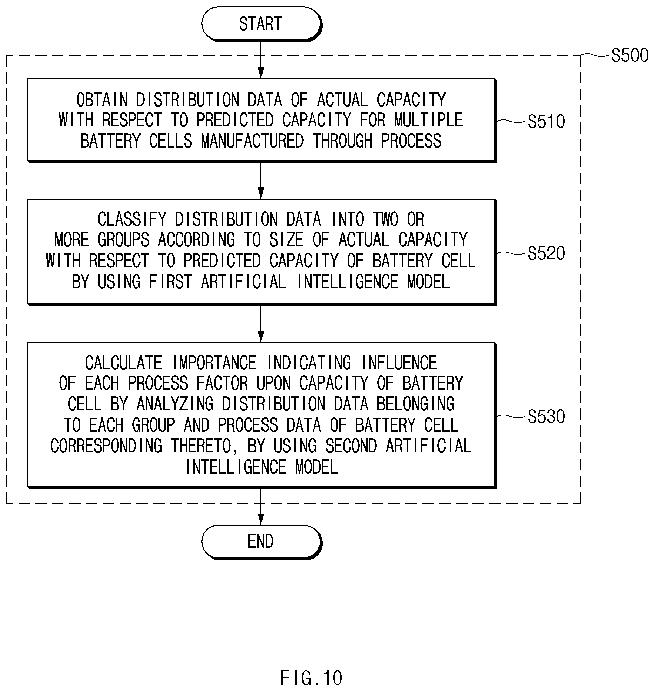

FIG. 10 is a flowchart showing in more detail an operation of determining a process factor of FIG. 9.

Referring to FIG. 10, operation S500 may include operation S510 of obtaining distribution data of an actual capacity with respect to a predicted capacity for multiple battery cells manufactured through a process, operation S520 of classifying the distribution data into two or more groups according to a size of an actual capacity with respect to an input predicted capacity of the battery cell by using a first artificial intelligence model, and operation S530 of calculating an importance indicating an influence of each process factor upon a capacity of the battery cell by analyzing the distribution data belong to each group and process data of the battery cell corresponding thereto by using a second artificial intelligence model.

According to an embodiment, the first artificial intelligence model, which is a machine learning-based classification model, discretize adjacent data to improve classification performance. For example, the first artificial intelligence model may use a DBSCAN-based model, without being limited thereto. The second artificial intelligence model may be trained to calculate an importance of each process factor based on a change level of the distribution data corresponding to a change of the process factor, for two or more preset process factors. More specifically, capacity differences (distribution data) between all process factors included in the process data according to presence/absence of intervention of a corresponding process factor may be compared, thereby calculating an importance of each process factor. The second artificial intelligence model may find process data classified into two or more groups by using a classification model, e.g., XGBClassifier, LightGBMClassifier, etc., and calculate an importance of each process factor through a permutation importance scheme. However, a type and a utilization method of a model are merely examples and thus are not limited thereto.

As such, the process factor affecting the capacity of the battery cell may be determined based on the importance of each process factor calculated using the artificial intelligence model, and the process factor may be controlled through a proper feedback, thereby improving the quality of the capacity of the battery cell.

According to an additional embodiment, in operation S520 of classifying the distribution data into two or more groups, the distribution data may be classified as the first group (e.g., a group belonging to 'GOOD' in FIG. 8) when the size of the actual capacity with respect to the input predicted capacity of the battery cell is greater than or equal to the first threshold value, and the distribution data may be classified as the second group (e.g., a group belonging to 'NOT GOOD' in FIG. 8) when the size of the actual capacity with respect to the input predicted capacity of the battery cell is less than or equal to the second threshold value.

Based on a classification result of operation S520, in operation S500 of determining a process factor, a process factor affecting a difference between the predicted capacity and the actual capacity of the battery cell may be determined as the positive process factor for the distribution data belonging to the first group (e.g., the group belonging to 'GOOD' in FIG. 8), and the process factor affecting the difference between the predicted capacity and the actual capacity of the battery cell may be determined as the negative process factor for the distribution data belonging to the second group (e.g., the group belonging to 'NOT GOOD' in FIG. 8). Moreover, in a subsequent battery manufacturing process, by increasing an influence of a positive process factor and decreasing an influence of a negative process factor, the quality of a battery cell capacity may be improved.

The battery cell data analysis method according to the embodiments may be implemented in the form of an application or a program instruction that is executable through various computer components and recorded in a computer-readable recording medium. The computer-readable recording medium may include a program instruction, a data file, a data structure and the like solely or in a combined manner.

According to the foregoing embodiments, a battery cell process data analysis system and method may be provided in which process factors affecting a capacity of a battery cell may be found through artificial intelligence-based data analysis. Moreover, by connecting data of different processes by using a key index, multiple process factors affecting a battery capacity in each process operation may be integrally managed.

Furthermore, by using the proposed system and method, it is possible to improve a capacity quality of a produced battery cell by finding a process factor that positively affects the capacity of the battery cell (e.g., that makes an actual capacity greater than a predicted capacity) and a process factor that negatively affects the capacity of the battery cell (e.g., makes the actual capacity less than the predicted capacity) and managing the process factors.

## Claims

1. A battery cell process data analysis system (10) comprising:
a process data obtaining unit (110) configured to obtain process data of a battery cell;
a predicted capacity estimating unit (120) configured to estimate a predicted capacity of the battery cell based on the process data;
an actual capacity measuring unit (130) configured to measure an actual capacity of the battery cell; and
a controller (140) configured to calculate a difference between the predicted capacity of the battery cell and the actual capacity of the battery cell and determine a process factor affecting the difference by using a trained artificial intelligence model;
**characterised in that**
the controller (140) is further configured to:
obtain distribution data of an actual capacity with respect to a predicted capacity for multiple battery cells manufactured through a process;
classify the distribution data into two or more groups according to a size of the actual capacity with respect to the predicted capacity of the battery cell, by using a first artificial intelligence model; and
calculate an importance indicating an influence of the process factor upon a capacity of the battery cell by analyzing distribution data belonging to each group and process data of the battery cell corresponding thereto, by using a second artificial intelligence model.

2. The battery cell process data analysis system of claim 1, wherein the predicted capacity estimating unit (120) is further configured to calculate a size of an electrode (210, 220) of an individual mono cell (20) based on a measured value of the mono cell (20) and estimate the predicted capacity of the battery cell where a plurality of mono cells (20) are stacked, based on the size of the electrode (210, 220) and an amount of an electrode active material loaded on the electrode (210, 220).

3. The battery cell process data analysis system of claim 1, wherein the second artificial intelligence model is trained to calculate an importance of each process factor based on a change of the distribution data according to presence/absence of the process factor for two or more process factors.

4. The battery cell process data analysis system of claim 3, wherein the controller (140) is further configured to:
classify the distribution data as a first group when a size of an actual capacity with respect to an input predicted capacity of the battery cell is greater than or equal to a first threshold value and classify the distribution data as a second group when the size of the actual capacity with respect to the input predicted capacity of the battery cell is less than or equal to a second threshold value; and
determine a process factor affecting the difference between the predicted capacity and the actual capacity of the battery cell as a positive process factor for distribution data belonging to the first group and determine a process factor affecting the difference between the predicted capacity and the actual capacity of the battery cell as a negative process factor for distribution data belonging to the second group.

5. The battery cell process data analysis system of claim 1, wherein the process data of the battery cell comprises data related to at least one of an electrode process, an assembly process, and an activation process,
the process data obtaining unit (110) is further configured to generate integrated process data by connecting process data related to different processes by using a key index, and
the controller (140) is further configured to determine a process factor affecting the difference between the predicted capacity and the actual capacity of the battery cell among process factors related to different processes, by using the integrated process data.

6. A battery cell process data analysis method comprising:
obtaining (S100) process data of a battery cell;
estimating (S200) a predicted capacity of the battery cell based on the process data;
measuring (S300) an actual capacity of the battery cell;
calculating (S400) a difference between the actual capacity and the predicted capacity of the battery cell; and
determining (S500) a process factor affecting the difference by using a trained artificial intelligence model;
**characterised in that**
the determining (S500) of the process factor comprises:
obtaining (S510) distribution data of an actual capacity with respect to a predicted capacity for multiple battery cells manufactured through a process;
classifying (S520) the distribution data into two or more groups according to a size of the actual capacity with respect to the predicted capacity of the battery cell, by using a first artificial intelligence model; and
calculating (S530) an importance indicating an influence of the process factor upon a capacity of the battery cell by analyzing distribution data belonging to each group and process data of the battery cell corresponding thereto, by using a second artificial intelligence model.

7. The battery cell process data analysis method of claim 6, wherein the estimating (S200) of the predicted capacity comprises:
calculating a size of an electrode (210, 220) of an individual mono cell (20) based on a measured value of the mono cell (20); and
estimating the predicted capacity of the battery cell where a plurality of individual mono cells (20) are stacked, based on the size of the electrode (210, 220) and an amount of an electrode active material loaded on the electrode (210, 220).

8. The battery cell process data analysis method of claim 6, wherein the second artificial intelligence model is trained to calculate an importance of each process factor based on a change of the distribution data according to presence/absence of the process factor for two or more preset process factors.

9. The battery cell process data analysis method of claim 8, wherein the classifying (S520) of the distribution data into the two or more groups comprises classifying the distribution data as a first group when a size of an actual capacity with respect to an input predicted capacity of the battery cell is greater than or equal to a first threshold value and classifying the distribution data as a second group when the size of the actual capacity with respect to the input predicted capacity of the battery cell is less than or equal to a second threshold value, and
the determining (S500) of the process factor comprises determining a process factor affecting the difference between the predicted capacity and the actual capacity of the battery cell as a positive process factor for distribution data belonging to the first group and determining a process factor affecting the difference between the predicted capacity and the actual capacity of the battery cell as a negative process factor for distribution data belonging to the second group.

10. The battery cell process data analysis method of claim 6, wherein the process data of the battery cell comprises data related to at least one of an electrode process, an assembly process, and an activation process,
the obtaining (S100) of the process data comprises generating integrated process data by connecting process data related to different processes by using a key index, and
the determining (S500) of the process factor comprises determining a process factor affecting the difference between the predicted capacity and the actual capacity of the battery cell among process factors related to different processes, by using the integrated process data.

## Patentansprüche

1. Batteriezellen-Prozessdaten-Analysesystem (10), umfassend:
eine Prozessdaten-Erfassungseinheit (110), welche dazu eingerichtet ist, Prozessdaten einer Batteriezelle zu erfassen;
eine Vorhergesagte-Kapazität-Schätzeinheit (120), welche dazu eingerichtet ist, eine vorhergesagte Kapazität der Batteriezelle auf Grundlage der Prozessdaten zu schätzen;
eine Tatsächliche-Kapazität-Messeinheit (130), welche dazu eingerichtet ist, eine tatsächliche Kapazität der Batteriezelle zu messen; und
eine Steuereinrichtung (140), welche dazu eingerichtet ist, eine Differenz zwischen der vorhergesagten Kapazität der Batteriezelle und der tatsächlichen Kapazität der Batteriezelle zu berechnen und einen die Differenz beeinflussenden Prozessfaktor unter Verwendung eines trainierten Künstliche-Intelligenz-Modells zu bestimmen;
**dadurch gekennzeichnet, dass** die Steuereinrichtung (140) ferner dazu eingerichtet ist:
Verteilungsdaten einer tatsächlichen Kapazität in Bezug auf eine vorhergesagte Kapazität für mehrere durch einen Prozess hergestellte Batteriezellen zu erfassen;
die Verteilungsdaten unter Verwendung eines ersten Künstliche-Intelligenz-Modells in zwei oder mehr Gruppen gemäß einer Größe der tatsächlichen Kapazität in Bezug auf die vorhergesagte Kapazität der Batteriezelle zu klassifizieren; und
eine Wichtigkeit, welche einen Einfluss des Prozessfaktors auf eine Kapazität der Batteriezelle angibt, durch ein Analysieren von zu jeder Gruppe gehörenden Verteilungsdaten und diesen entsprechenden Prozessdaten der Batteriezelle unter Verwendung eines zweiten Künstliche-Intelligenz-Modells zu berechnen.

2. Batteriezellen-Prozessdaten-Analysesystem nach Anspruch 1, wobei die Vorhergesagte-Kapazität-Schätzeinheit (120) ferner dazu eingerichtet ist, eine Größe einer Elektrode (210, 220) einer einzelnen Monozelle (20) auf Grundlage eines Messwerts der Monozelle (20) zu berechnen und die vorhergesagte Kapazität der Batteriezelle, in welcher eine Mehrzahl von Monozellen (20) gestapelt ist, auf Grundlage der Größe der Elektrode (210, 220) und einer auf die Elektrode (210, 220) aufgebrachten Menge eines Elektrodenaktivmaterials zu schätzen.

3. Batteriezellen-Prozessdaten-Analysesystem nach Anspruch 1, wobei das zweite Künstliche-Intelligenz-Modell darauf trainiert ist, eine Wichtigkeit jedes Prozessfaktors auf Grundlage einer Änderung der Verteilungsdaten gemäß einem Vorhandensein/Nichtvorhandensein des Prozessfaktors für zwei oder mehr Prozessfaktoren zu berechnen.

4. Batteriezellen-Prozessdaten-Analysesystem nach Anspruch 3, wobei die Steuereinrichtung (140) ferner dazu eingerichtet ist:
die Verteilungsdaten als eine erste Gruppe zu klassifizieren, wenn eine Größe einer tatsächlichen Kapazität in Bezug auf eine eingegebene vorhergesagte Kapazität der Batteriezelle größer als oder gleich wie ein erster Schwellenwert ist, und die Verteilungsdaten als eine zweite Gruppe zu klassifizieren, wenn die Größe der tatsächlichen Kapazität in Bezug auf die eingegebene vorhergesagte Kapazität der Batteriezelle kleiner als oder gleich wie ein zweiter Schwellenwert ist; und
einen Prozessfaktor, welcher die Differenz zwischen der vorhergesagten Kapazität und der tatsächlichen Kapazität der Batteriezelle beeinflusst, für zu der ersten Gruppe gehörende Verteilungsdaten als einen positiven Prozessfaktor zu bestimmen und einen Prozessfaktor, welcher die Differenz zwischen der vorhergesagten Kapazität und der tatsächlichen Kapazität der Batteriezelle beeinflusst, für zu der zweiten Gruppe gehörende Verteilungsdaten als einen negativen Prozessfaktor zu bestimmen.

5. Batteriezellen-Prozessdaten-Analysesystem nach Anspruch 1, wobei die Prozessdaten der Batteriezelle Daten umfassen, welche sich auf wenigstens eines aus einem Elektrodenprozess, einem Montageprozess und einem Aktivierungsprozess beziehen,
die Prozessdaten-Erfassungseinheit (110) ferner dazu eingerichtet ist, integrierte Prozessdaten durch ein Verbinden von Prozessdaten, welche sich auf verschiedene Prozesse beziehen, unter Verwendung eines Schlüsselindex zu erzeugen, und
die Steuereinrichtung (140) ferner dazu eingerichtet ist, unter Verwendung der integrierten Prozessdaten einen Prozessfaktor, welcher die Differenz zwischen der vorhergesagten Kapazität und der tatsächlichen Kapazität der Batteriezelle beeinflusst, unter Prozessfaktoren zu bestimmen, welche sich auf verschiedene Prozesse beziehen.

6. Batteriezellen-Prozessdaten-Analyseverfahren, umfassend:
Erfassen (S100) von Prozessdaten einer Batteriezelle;
Schätzen (S200) einer vorhergesagten Kapazität der Batteriezelle auf Grundlage der Prozessdaten;
Messen (S300) einer tatsächlichen Kapazität der Batteriezelle;
Berechnen (S400) einer Differenz zwischen der tatsächlichen Kapazität und der vorhergesagten Kapazität der Batteriezelle; und
Bestimmen (S500) eines die Differenz beeinflussenden Prozessfaktors unter Verwendung eines trainierten Künstliche-Intelligenz-Modells;
**dadurch gekennzeichnet, dass** das Bestimmen (S500) des Prozessfaktors umfasst:
Erfassen (S510) von Verteilungsdaten einer tatsächlichen Kapazität in Bezug auf eine vorhergesagte Kapazität für mehrere durch einen Prozess hergestellte Batteriezellen;
Klassifizieren (S520) der Verteilungsdaten in zwei oder mehr Gruppen gemäß einer Größe der tatsächlichen Kapazität in Bezug auf die vorhergesagte Kapazität der Batteriezelle unter Verwendung eines ersten Künstliche-Intelligenz-Modells; und
Berechnen (S530) einer Wichtigkeit, welche einen Einfluss des Prozessfaktors auf eine Kapazität der Batteriezelle angibt, durch ein Analysieren von zu jeder Gruppe gehörenden Verteilungsdaten und diesen entsprechenden Prozessdaten der Batteriezelle unter Verwendung eines zweiten Künstliche-Intelligenz-Modells.

7. Batteriezellen-Prozessdaten-Analyseverfahren nach Anspruch 6, wobei das Schätzen (S200) der vorhergesagten Kapazität umfasst:
Berechnen einer Größe einer Elektrode (210, 220) einer einzelnen Monozelle (20) auf Grundlage eines Messwerts der Monozelle (20); und
Schätzen der vorhergesagten Kapazität der Batteriezelle, in welcher eine Mehrzahl einzelner Monozellen (20) gestapelt ist, auf Grundlage der Größe der Elektrode (210, 220) und einer auf die Elektrode (210, 220) aufgebrachten Menge eines Elektrodenaktivmaterials.

8. Batteriezellen-Prozessdaten-Analyseverfahren nach Anspruch 6, wobei das zweite Künstliche-Intelligenz-Modell darauf trainiert ist, eine Wichtigkeit jedes Prozessfaktors auf Grundlage einer Änderung der Verteilungsdaten gemäß einem Vorhandensein/Nichtvorhandensein des Prozessfaktors für zwei oder mehr vorgegebene Prozessfaktoren zu berechnen.

9. Batteriezellen-Prozessdaten-Analyseverfahren nach Anspruch 8, wobei das Klassifizieren (S520) der Verteilungsdaten in die zwei oder mehr Gruppen ein Klassifizieren der Verteilungsdaten als eine erste Gruppe, wenn eine Größe einer tatsächlichen Kapazität in Bezug auf eine eingegebene vorhergesagte Kapazität der Batteriezelle größer als oder gleich wie ein erster Schwellenwert ist, und ein Klassifizieren der Verteilungsdaten als eine zweite Gruppe umfasst, wenn die Größe der tatsächlichen Kapazität in Bezug auf die eingegebene vorhergesagte Kapazität der Batteriezelle kleiner als oder gleich wie ein zweiter Schwellenwert ist, und
das Bestimmen (S500) des Prozessfaktors ein Bestimmen eines Prozessfaktors, welcher die Differenz zwischen der vorhergesagten Kapazität und der tatsächlichen Kapazität der Batteriezelle beeinflusst, als einen positiven Prozessfaktor für zu der ersten Gruppe gehörende Verteilungsdaten und ein Bestimmen eines Prozessfaktors, welcher die Differenz zwischen der vorhergesagten Kapazität und der tatsächlichen Kapazität der Batteriezelle beeinflusst, als einen negativen Prozessfaktor für zu der zweiten Gruppe gehörende Verteilungsdaten umfasst.

10. Batteriezellen-Prozessdaten-Analyseverfahren nach Anspruch 6, wobei die Prozessdaten der Batteriezelle Daten umfassen, welche sich auf wenigstens eines aus einem Elektrodenprozess, einem Montageprozess und einem Aktivierungsprozess beziehen,
das Erfassen (S100) der Prozessdaten ein Erzeugen integrierter Prozessdaten durch ein Verbinden von Prozessdaten, welche sich auf verschiedene Prozesse beziehen, unter Verwendung eines Schlüsselindex umfasst und
das Bestimmen (S500) des Prozessfaktors ein Bestimmen eines Prozessfaktors, welcher die Differenz zwischen der vorhergesagten Kapazität und der tatsächlichen Kapazität der Batteriezelle beeinflusst, unter Prozessfaktoren, welche sich auf verschiedene Prozesse beziehen, unter Verwendung der integrierten Prozessdaten umfasst.

## Revendications

1. Système d'analyse de données de processus d'élément de batterie (10) comprenant :
une unité d'obtention de données de processus (110) configurée pour obtenir des données de processus d'un élément de batterie ;
une unité d'estimation de capacité prédite (120) configurée pour estimer une capacité prédite de l'élément de batterie sur la base des données de processus ;
une unité de mesure de capacité réelle (130) configurée pour mesurer une capacité réelle de l'élément de batterie ; et
un dispositif de commande (140) configuré pour calculer une différence entre la capacité prédite de l'élément de batterie et la capacité réelle de l'élément de batterie et déterminer un facteur de processus affectant la différence en utilisant un modèle d'intelligence artificielle formé ;
**caractérisé en ce que** le dispositif de commande (140) est en outre configuré pour :
obtenir des données de distribution d'une capacité réelle par rapport à une capacité prédite pour plusieurs éléments de batterie fabriqués suivant un processus ;
classifier les données de distribution en deux groupes ou plus selon une grandeur de la capacité réelle par rapport à la capacité prédite de l'élément de batterie, en utilisant un premier modèle d'intelligence artificielle ; et
calculer une importance indiquant une influence du facteur de processus sur une capacité de l'élément de batterie en analysant des données de distribution appartenant à chaque groupe et des données de processus de l'élément de batterie correspondant à celui-ci, en utilisant un second modèle d'intelligence artificielle.

2. Système d'analyse de données de processus d'élément de batterie selon la revendication 1, dans lequel l'unité d'estimation de capacité prédite (120) est en outre configurée pour calculer une taille d'une électrode (210, 220) d'un monoélément (20) individuel sur la base d'une valeur mesurée du monoélément (20) et estimer la capacité prédite de l'élément de batterie où une pluralité de monoéléments (20) sont empilés, sur la base de la taille de l'électrode (210, 220) et d'une quantité d'un matériau actif d'électrode chargé sur l'électrode (210, 220).

3. Système d'analyse de données de processus d'élément de batterie selon la revendication 1, dans lequel le second modèle d'intelligence artificielle est formé au calcul d'une importance de chaque facteur de processus sur la base d'un changement des données de distribution selon la présence/l'absence du facteur de processus pour deux facteurs de processus ou plus.

4. Système d'analyse de données de processus d'élément de batterie selon la revendication 3, dans lequel le dispositif de commande (140) est en outre configuré pour :
classer les données de distribution en un premier groupe lorsqu'une grandeur d'une capacité réelle par rapport à une capacité prédite d'entrée de l'élément de batterie est supérieure ou égale à une première valeur seuil, et classer les données de distribution en un second groupe lorsque la grandeur de la capacité réelle par rapport à la capacité prédite d'entrée de l'élément de batterie est inférieure ou égale à une seconde valeur seuil ; et
déterminer un facteur de processus affectant la différence entre la capacité prédite et la capacité réelle de l'élément de batterie en tant que facteur de processus positif pour les données de distribution appartenant au premier groupe et déterminer un facteur de processus affectant la différence entre la capacité prédite et la capacité réelle de l'élément de batterie en tant que facteur de processus négatif pour les données de distribution appartenant au second groupe.

5. Système d'analyse de données de processus d'élément de batterie selon la revendication 1, dans lequel les données de processus de l'élément de batterie comprennent des données liées à au moins un parmi un processus d'électrode, un processus d'assemblage et un processus d'activation,
l'unité d'obtention de données de processus (110) est en outre configurée pour générer des données de processus intégrées en mettant en relation des données de processus liées à différents processus en utilisant un indice clé, et
le dispositif de commande (140) est en outre configuré pour déterminer un facteur de processus affectant la différence entre la capacité prédite et la capacité réelle de l'élément de batterie parmi les facteurs de processus liés à différents processus, en utilisant les données de processus intégrées.

6. Procédé d'analyse de données de processus d'élément de batterie comprenant :
l'obtention (S100) de données de processus d'un élément de batterie ;
l'estimation (S200) d'une capacité prédite de l'élément de batterie sur la base des données de processus ;
la mesure (S300) d'une capacité réelle de l'élément de batterie ;
le calcul (S400) d'une différence entre la capacité réelle et la capacité prédite de l'élément de batterie ; et
la détermination (S500) d'un facteur de processus affectant la différence en utilisant un modèle d'intelligence artificielle formé ;
**caractérisé en ce que** la détermination (S500) du facteur de processus comprend :
l'obtention (S510) de données de distribution d'une capacité réelle par rapport à une capacité prédite pour plusieurs éléments de batterie fabriqués suivant un processus ;
la classification (S520) des données de distribution en deux groupes ou plus selon une grandeur de la capacité réelle par rapport à la capacité prédite de l'élément de batterie, en utilisant un premier modèle d'intelligence artificielle ; et
le calcul (S530) d'une importance indiquant une influence du facteur de processus sur une capacité de l'élément de batterie en analysant des données de distribution appartenant à chaque groupe et des données de processus de l'élément de batterie correspondant à celui-ci, en utilisant un second modèle d'intelligence artificielle.

7. Procédé d'analyse de données de processus d'élément de batterie selon la revendication 6, dans lequel l'estimation (S200) de la capacité prédite comprend :
le calcul d'une taille d'une électrode (210, 220) d'un monoélément (20) individuel sur la base d'une valeur mesurée du monoélément (20) ; et
l'estimation de la capacité prédite de l'élément de batterie où une pluralité de monoéléments (20) individuels sont empilés, sur la base de la taille de l'électrode (210, 220) et d'une quantité d'un matériau actif d'électrode chargé sur l'électrode (210, 220).

8. Procédé d'analyse de données de processus d'élément de batterie selon la revendication 6, dans lequel le second modèle d'intelligence artificielle est formé au calcul d'une importance de chaque facteur de processus sur la base d'un changement des données de distribution selon la présence/l'absence du facteur de processus pour deux facteurs de processus prédéfinis ou plus.

9. Procédé d'analyse de données de processus d'élément de batterie selon la revendication 8, dans lequel le classement (S520) des données de distribution en les deux groupes ou plus comprend le classement des données de distribution en un premier groupe lorsqu'une grandeur d'une capacité réelle par rapport à une capacité prédite d'entrée de l'élément de batterie est supérieure ou égale à une première valeur seuil, et le classement des données de distribution en un second groupe lorsque la grandeur de la capacité réelle par rapport à la capacité prédite d'entrée de l'élément de batterie est inférieure ou égale à une seconde valeur seuil, et
la détermination (S500) du facteur de processus comprend la détermination d'un facteur de processus affectant la différence entre la capacité prédite et la capacité réelle de l'élément de batterie en tant que facteur de processus positif pour les données de distribution appartenant au premier groupe et la détermination d'un facteur de processus affectant la différence entre la capacité prédite et la capacité réelle de l'élément de batterie en tant que facteur de processus négatif pour les données de distribution appartenant au second groupe.

10. Procédé d'analyse de données de processus d'élément de batterie selon la revendication 6, dans lequel les données de processus de l'élément de batterie comprennent des données liées à au moins un parmi un processus d'électrode, un processus d'assemblage et un processus d'activation,
l'obtention (S100) des données de processus comprend la génération de données de processus intégrées en mettant en relation des données de processus liées à différents processus en utilisant un indice clé, et
la détermination (S500) du facteur de processus comprend la détermination d'un facteur de processus affectant la différence entre la capacité prédite et la capacité réelle de l'élément de batterie parmi des facteurs de processus liés à différents processus, en utilisant les données de processus intégrées.
